(19) Europäisches Patentamt

European Patent Office

Office européen des brevets

(11) **EP 1 043 741 A2**

(12) **EUROPÄISCHE PATENTANMELDUNG**

(43) Veröffentlichungstag:
**11.10.2000 Patentblatt 2000/41**

(51) Int. Cl.⁷: **H01G 7/06**

(21) Anmeldenummer: **00201150.0**

(22) Anmeldetag: **28.03.2000**

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **03.04.1999 DE 19915247**

(71) Anmelder:
• **Philips Corporate Intellectual Property GmbH**
**52064 Aachen (DE)**
Benannte Vertragsstaaten:
**DE**
• **Koninklijke Philips Electronics N.V.**
**5621 BA  Eindhoven (NL)**
Benannte Vertragsstaaten:
**FR GB**

(72) Erfinder:
• **Klee, Mareike,**
**Philips Corporate Int. Pty. GmbH**
**52064 Aachen (DE)**

• **Kiewitt, Rainer,**
**Philips Corporate Int. Pty. GmbH**
**52064 Aachen (DE)**
• **Löbl, Hans-Peter,**
**Philips Corporate Int. Pty. GmbH**
**52064 Aachen (DE)**
• **van Oppen, Paul,**
**Philips Corporate Int. Pty. GmbH**
**52064 Aachen (DE)**
• **Derksen, Rob,**
**Philips Corporate Int. Pty. GmbH**
**52064 Aachen (DE)**

(74) Vertreter:
**Volmer, Georg, Dipl.-Ing.**
**Philips Corporate Intellectual Property GmbH,**
**Habsburgerallee 11**
**52064 Aachen (DE)**

(54)     **Spannungsabhängiger Dünnschichtkondensator**

(57)     Die Erfindung beschreibt ein passives kerami- sches Bauelement mit einem Trägersubstrat (1), einer ersten und einer zweiten Elektroden (2,6) und einem ferroelektrischen Dielektrikum (5). Die Elektroden (2,6) und das Dielektrikum (5) enthalten bevorzugt einen Mehrschichtaufbau mit wenigstens einer ersten und einer zweiten Schicht. Durch Anlegen einer elektrischen Spannung an die Elektroden (2,6) lässt sich aufgrund der Feldabhängigkeit der Dielektrizitätskonstanten $\varepsilon_r$ des Dielektrikums (5) der Kapazitätswert C des Kon- densators variieren.

Derartige Bauelemente können in Filteranordnun- gen oder in Verzögerungsleitungen oder anstelle von Kapazitätsvariations-Dioden beim Bau von spannungs- gesteuerten Oszillatoren verwendet werden.

FIG. 1

**Beschreibung**

Die Erfindung betrifft ein keramisches, passives Bauelement, welches ein Trägersubstrat, wenigstens eine darüberliegende erste Elektrode, wenigstens ein darüberliegendes Dielektrikum und wenigstens eine darüberliegende zweite Elektrode aufweist. Die Erfindung betrifft auch Bauteile, bei denen wenigstens ein keramisches, passives Bauelement mit obigen Aufbau verwendet wurde.

Kapazitätsvariations-Dioden (auch Varicaps genannt) sind Dioden bei denen die Spannungsabhängigkeit eines pn-Überganges praktisch verwertet wird. Jeder pn-Übergang bildet einen Kondensator mit der p- und der n-Zone als Platten und der dazwischen liegenden Sperrschicht als Dielektrikum. Die Dicke der Sperrschicht steigt mit der angelegten Sperrspannung, wodurch die Kapazität des pn-Überganges sinkt.

Kapazitätsvariations-Dioden sind in verschiedenen Ausführungen erhältlich. Typisch sind Betriebsspannungen von 12 bis 30 V und eine um einen Faktor 10 bis 20 veränderbare Kapazität. Für Anwendungen in mobilen Telefonen sind niedrigere Spannungen im Bereich von 3 bis 5 V gebräuchlich und der Abstimmbereich ist ein Faktor zwischen 2 und 4. In diesem Fall variiert die Kapazität der Dioden üblicherweise zwischen 20 und 40 pF. Eingesetzt werden diese Halbleiter-Bauelemente unter anderem zum Bau von spannungsgesteuerten Oszillatoren (VCOs = voltage controlled oscillators).

Gerade für Anwendungen im Mobilfunkbereich geht der Trend zu niedrigeren Spannungen und zu hohen Frequenzen (GHz). Der Bau von Kapazitätsvariations-Dioden für diesen Gebrauch gestaltet sich aber immer schwieriger, speziell wenn die Abmessung der Bauelemente möglichst klein sein soll. Aber auch im Hinblick auf den effektiven Serienwiderstand stoßen die Halbleiterbauelemente an ihre Grenzen. Außerdem sind die Kosten der Halbleiterprozesse zur Herstellung von Kapazitätsvariations-Dioden sehr hoch.

Der Erfindung liegt die Aufgabe zugrunde, ein Bauelement bereitzustellen, welches eine abstimmbare Kapazität sowie einen geringen effektiven Serienwiderstand besitzt und möglichst preiswert herzustellen ist.

Diese Aufgabe wird gelöst durch ein keramisches, passives Bauelement, welches ein Trägersubstrat, wenigstens eine darüberliegende erste Elektrode, wenigstens ein darüberliegendes Dielektrikum und wenigstens eine darüberliegende zweite Elektrode aufweist, bei dem das Dielektrikum eine ferroelektrische Keramik mit einer spannungsabhängigen relativen Dielektrizitätskonstanten $\varepsilon_r$ enthält.

Bei gegebener geometrischer Abmessung (Fläche A, Elektrodenabstand d) eines Kondensators errechnet sich die Kapazität gemäß der Formel

$$C = (\varepsilon_r \cdot \varepsilon_0 \cdot A)/d.$$

Eine Spannungsabhängigkeit der Kapazität C ist damit durch die Spannungsabhängigkeit der Dielektrizitätskonstanten $\varepsilon_r$ gegeben. Viele Dielektrika weisen eine geringe Höhe der Dielektrizitätskonstanten $\varepsilon_r$ und eine niedrige Feldabhängigkeit $\varepsilon_r$ (E) auf. Eine Ausnahme bilden ferroelektrische Materialien, bei denen sich $\varepsilon_r$ durch Anlegen eines elektrischen Feldes E ändern lässt. Damit kann man die Kapazität C eines Kondensators durch Anlegen einer elektrischen Spannung an die Elektroden variieren.

Ein Vorteil dieser Bauelemente ist, dass sie einerseits im Gegensatz zu Kapazitätsvariations-Dioden nicht polar sind und andererseits preiswerter als die Halbleiterbauelemente herzustellen sind.

Es ist besonders bevorzugt dass als ferroelektrische Keramik mit einer spannungsabhängigen relativen Dielektrizitätskonstanten $\varepsilon_r$ $Pb(Zr_xTi_{1-x})O_3$ ($0 \leq x \leq 1$) mit und ohne Bleiüberschuss, $Ba_{1-x}Sr_xTiO_3$ ($0 \leq x \leq 1$), $Pb_{1-1.5y}La_y(Zr_xTi_{1-x})O_3$ ($0 \leq x \leq 1$, $0 \leq y \leq 0.2$), $Pb(Zr_xTi_{1-x})O_3$ ($0 \leq x \leq 1$) mit Nb-Dotierungen, $Pb_{1-\alpha y}La_yTiO_3$ ($0 \leq y \leq 0.3$, $1.3 \leq \alpha \leq 1.5$), $(Pb,Ca)TiO_3$, $BaTiO_3$ mit und ohne Dotierungen, $SrZr_xTi_{1-x}O_3$ ($0 \leq x \leq 1$) mit und ohne Mn Dotierungen, $BaZr_xTi_{1-x}O_3$ ($0 \leq x \leq 1$), $SrTiO_3$ mir Dotierungen von z.B. La, Nb, Fe oder Mn, $[Pb(Mg_{1/3}Nb_{2/3})O_3]_x$-$[PbTiO_3]_{1-x}$ ($0 \leq x \leq 1$), $(Pb,Ba,Sr)(Mg_{1/3}Nb_{2/3})_xTi_y(Zn_{1/3}Nb_{2/3})_{1-x-y}O_3$ ($0 \leq x \leq 1$, $0 \leq y \leq 1$, $x + y \leq 1$), $PbNb_{4/5x}((Zr_{0.6}Sn_{0.4})_{1-y}Ti_y))_{1-x}O_3$ ($0 \leq x \leq 0.9$, $0 \leq y \leq 1$), $(Ba_{1-x}Ca_x)TiO_3$ ($0 \leq x \leq 1$), $(Ba_{1-x}Sr_x)TiO_3$ ($0 \leq x \leq 1$), $(Ba_{1-x}Pb_x)TiO_3$ ($0 \leq x \leq 1$), $(Ba_{1-x}Sr_x)(Ti_{1-x}Zr_x)O_3$ ($0 \leq x \leq 1$, $0 \leq y \leq 1$),

     a) $Pb(Mg_{1/2}W_{1/2})O_3$
     b) $Pb(Fe_{1/2}Nb_{1/2})O_3$
     c) $Pb(Fe_{2/3}W_{1/3})O_3$
     d) $Pb(Ni_{1/3}Nb_{2/3})O_3$
     e) $Pb(Zn_{1/3}Nb_{2/3})O_3$
     f) $Pb(Sc_{1/2}Ta_{1/2})O_3$

sowie Kombinationen der Verbindungen a)- f) mit $PbTiO_3$ und $Pb(Mg_{1/3}Nb_{2/3})O_3$ mit und ohne Bleiüberschuss verwendet wird.

All diese ferroelektrischen Keramikmaterialien besitzen eine hohe und spannungsabhängige relative Dielektrizitätskonstante $\varepsilon_r$.

In einer anderen bevorzugten Ausführung enthält die erste Elektrode und/oder die zweite Elektrode wenigstens eine erste und eine zweite elektrisch leitende Schicht.

Es ist bevorzugt, dass die erste elektrisch leitende Schicht der Elektroden Ti, Cr, $Ni_xCr_y$ ($0 \leq x \leq 1$, $0 \leq y \leq 1$) oder $Ti_xW_y$ ($0 \leq x \leq 1$, $0 \leq y \leq 1$) enthält. Diese Schichten dienen als Haftvermittler.

Es ist weiterhin bevorzugt, dass die zweite elektrisch leitende Schicht der Elektroden ein Metall oder eine Legierung enthält.

Der elektrische Strom wird hauptsächlich von der zweiten, gut leitenden Schicht getragen. Eine hohe Leitfähigkeit der verwendeten Materialien ermöglichen einen geringen effektiven Serienwiderstand (ESR) und geringe parasitäre Induktivitäten (ESL).

Eine vorteilhafte Ausführung sieht vor, dass das Trägersubstrat ein keramisches Material, ein keramisches Material mit einer Planarisierungsschicht aus Glas, ein glaskeramisches Material, ein Glasmaterial oder Silicium enthält.

Ein Trägersubstrat aus einem keramischen Material, einem keramischen Material mit einer Planarisierungsschicht aus Glas, einem glaskeramischen Material oder einem Glasmaterial ist kostengünstig herzustellen und die Prozesskosten für diese Komponente können niedrig gehalten werden. Bei Integration des passiven, keramischen Bauelementes in IC's ist das Trägersubstrat aus Silicium und ist gegebenenfalls mit einer Passivierungsschicht aus $SiO_2$ versehen.

Eine weitere bevorzugte Ausführung sieht vor, dass das Dielektrikum multiple Schichten aufweist.

Durch Verwendung von multiplen Schichten, beispielsweise Doppel-, Dreifach- oder Vierfachschichten, kann das ungünstige Temperaturverhalten einiger ferroelektrischer Materialien ausgeglichen und die Temperaturabhängigkeit des Kapazitätswertes C verbessert werden.

Es ist auch bevorzugt, dass über dem gesamten Bauelement eine Schutzschicht aus einem anorganischen Material und/oder einem organischen Material aufgebracht ist.

Durch die Schutzschicht werden die darunterliegenden Schichten vor mechanischer Beanspruchung und Korrosion durch Feuchtigkeit geschützt.

Die Erfindung betrifft auch Bauteile, insbesondere abstimmbare Filter oder Verzögerungsleitungen oder spannungsgesteuerte Oszillatoren, die als kapazitive Komponente ein keramisches, passives Bauelement, welches ein Trägersubstrat, wenigstens eine darüberliegende erste Elektrode, wenigstens ein darüberliegendes Dielektrikum und wenigstens eine darüberliegende zweite Elektrode aufweist, enthalten, dadurch gekennzeichnet, dass das Dielektrikum eine ferroelektrische Keramik mit einer spannungsabhängigen relativen Dielektrizitätskonstanten $\varepsilon_r$ enthält.

Von Vorteil ist die Verwendung des erfindungsgemäßen Bauelementes beispielsweise in einem abstimmbaren RCL-Filter, einer passiven Verzögerungsleitung mir elektrisch veränderbarer Verzögerungszeit oder anstelle einer Kapazitätsvariations-Diode in spannungsgesteuerten Oszillatoren, da das erfindungsgemäße Bauelement mit anderen Komponenten auf einem Substrat aufgebracht werden kann und somit preiswerte Bauteile mit einer kleinen Baugröße hergestellt werden können.

Weiterhin betrifft die Erfindung auch die Verwendung eines keramischen, passiven Bauelementes, welches ein Trägersubstrat, wenigstens eine darüberliegende erste Elektrode, wenigstens ein darüberliegendes Dielektrikum mit einer spannungsabhängigen relativen Dielektrizitätskonstanten $\varepsilon_r$ und wenigstens eine darüberliegende zweite Elektrode aufweist, als kapazitive Komponente.

Im folgenden soll die Erfindung anhand von fünf Figuren und dreier Ausführungsbeispiele erläutert werden. Dabei zeigt

Fig. 1 im Querschnitt den schematischen Aufbau eines keramischen, passiven Bauelementes,

Fig. 2 den Verlauf der Kapazität mit der angelegten Spannung eines erfindungsgemäßen keramischen, passiven Bauelementes,

Fig. 3 die Schaltungsanordnung eines RCL-Filters,

Fig. 4 die Filtercharakteristik eines RCL-Filters, der als eine kapazitive Komponente ein erfindungsgemäßes Bauelement enthält und

Fig. 5 die Schaltungsanordnung eines passiven LC-Verzögerungsgliedes.

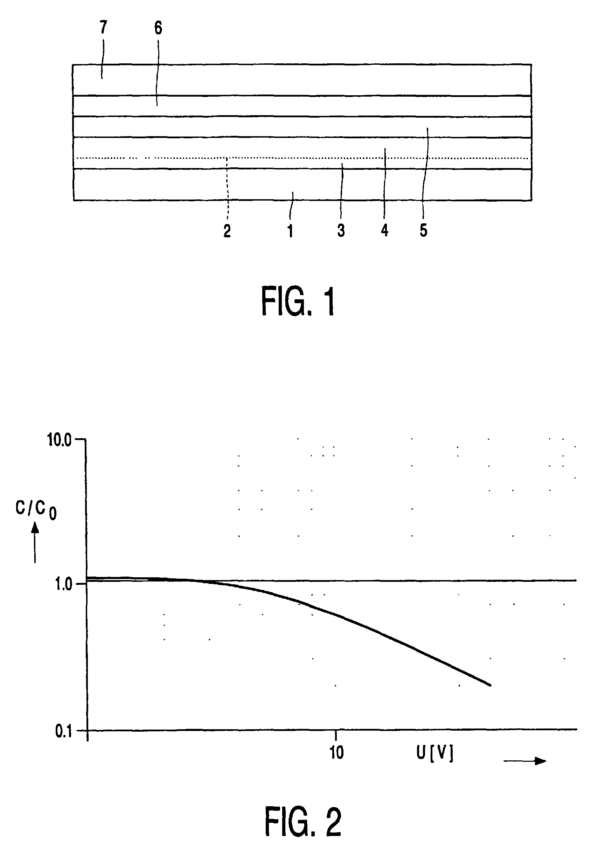

Gemäß Fig. 1 weist ein keramisches, passives Bauelement ein Trägersubstrat 1 auf, welches zum Beispiel aus einem keramischen Material, einem keramischen Material mit einer Planarisierungsschicht aus Glas, einem glaskeramischen Material, einem Glasmaterial oder Silicium mit Passivierungsschicht ist. Auf dem Trägersubstrat 1 befindet sich eine erste Elektrode 2, welche eine erste elektrisch leitende Schicht 3 aus beispielsweise Ti, Cr, $Ni_xCr_y$ ($0 \leq x \leq 1$, $0 \leq y \leq 1$) oder $Ti_xW_y$ ($0 \leq x \leq 1$, $0 \leq y \leq 1$) und eine zweite elektrisch leitende Schicht 4 zum Beispiel Pt, Ag, Ir, $Ag_{1-x}Pt_x$ ($0 \leq x \leq 1$), Ni, Cu, W, $Ag_{1-x}Pd_x$ ($0 \leq x \leq 1$), Al, Al dotiert mit Cu, Al dotiert mit Si oder Al dotiert mit Mg enthält. Ein Dielektrikum 5 beispielsweise aus $Pb(Zr_xTi_{1-x})O_3$ ($0 \leq x \leq 1$) mit und ohne Bleiüberschuss, $Ba_{1-x}Sr_xTiO_3$ ($0 \leq x \leq 1$), $Pb_{1-1.5y}La_y(Zr_xTi_{1-x})O_3$ ($0 \leq x \leq 1$, $0 \leq y \leq 0.2$), $Pb(Zr_xTi_{1-x})O_3$ ($0 \leq x \leq 1$) mit Nb-Dotierungen, $Pb_{1-\alpha y}La_yTiO_3$ ($0 \leq y \leq 0.3$, $1.3 \leq \alpha \leq 1.5$), $(Pb,Ca)TiO_3$, $BaTiO_3$ mit und ohne Dotierungen, $SrZr_xTi_{1-x}O_3$ ($0 \leq x \leq 1$) mit und ohne Mn Dotierungen, $BaZr_xTi_{1-x}O_3$ ($0 \leq x \leq 1$), $SrTiO_3$ mit Dotierungen von z.B. La, Nb, Fe oder Mn, $[Pb(Mg_{1/3}Nb_{2/3})O_3]_x-[PbTiO_3]_{1-x}$ ($0 \leq x \leq 1$), $(Pb,Ba,Sr)(Mg_{1/3}Nb_{2/3})_xTi_y(Zn_{1/3}Nb_{2/3})_{1-x-y}O_3$ ($0 \leq x \leq 1$, $0 \leq y \leq 1$, $x+y \leq 1$), $PbNb_{4/5x}((Zr_{0.6}Sn_{0.4})_{1-y}Ti_y))_{1-x}O_3$ ($0 \leq x \leq 0.9$, $0 \leq y \leq 1$), $(Ba_{1-x}Ca_x)TiO_3$ ($0 \leq x \leq 1$), $(Ba_{1-x}Sr_x)TiO_3$ ($0 \leq x \leq 1$), $(Ba_{1-x}Pb_x)TiO_3$ ($0 \leq x \leq 1$), $(Ba_{1-x}Sr_x)(Ti_{1-x}Zr_x)O_3$ ($0 \leq x \leq 1$, $0 \leq y \leq 1$),

    a) $Pb(Mg_{1/2}W_{1/2})O_3$
    b) $Pb(Fe_{1/2}Nb_{1/2})O_3$
    c) $Pb(Fe_{2/3}W_{1/3})O_3$
    d) $Pb(Ni_{1/3}Nb_{2/3})O_3$
    e) $Pb(Zn_{1/3}Nb_{2/3})O_3$
    f) $Pb(Sc_{1/2}Ta_{1/2})O_3$

sowie Kombinationen der Verbindungen a)- f) mit

PbTiO$_3$ und Pb(Mg$_{1/3}$Nb$_{2/3}$)O$_3$ mit und ohne Bleiüberschuss wird auf der erste Elektrode 2 aufgebracht. Auf dem Dielektrikum 5 befindet sich eine zweite Elektrode 6, welche beispielsweise aus Pt, Ag, Ir, Ag$_{1-x}$Pt$_x$ (0 ≤ x ≤ 1), Ni, Cu, W, Ag$_{1-x}$Pd$_x$ (0 ≤ x ≤ 1), Al, Al dotiert mit Cu, Al dotiert mit Si oder Al dotiert mit Mg oder YBa$_2$CuO$_x$ ist. Über dieser zweiten Elektrode 6 wird eine Schutzschicht 7 aus einem organischen und/oder anorganischen Material aufgebracht. Als organisches Material kann beispielsweise Polybenzocyclobuten oder Polyimid und als anorganisches Material kann zum Beispiel Si$_3$N$_4$, SiO$_2$ oder Si$_x$O$_y$N$_x$ (0 ≤ x ≤ 1, 0 ≤ y ≤ 1, 0 ≤ z ≤ 1) verwendet werden.

Alternativ kann die erste Elektrode 2 nur eine elektrisch leitenden Schicht aus zum Beispiel Pt, Ag, Ir, Ag$_{1-x}$Pt$_x$ (0 ≤ x ≤ 1), Ni, Cu, W, Ag$_{1-x}$Pd$_x$ (0 ≤ x ≤ 1), Al, Al dotiert mit Cu, Al dotiert mit Si oder Al dotiert mit Mg oder YBa$_2$CuO$_x$ aufweisen. Außerdem kann die zweite Elektrode 6 wenigstens eine erste und eine zweite elektrisch leitende Schicht aufweisen. Die erste elektrisch leitende Schicht kann beispielsweise Ti, Cr, Ni$_x$Cr$_y$ (0 ≤ x ≤ 1, 0 ≤ y ≤ 1) oder Ti$_x$W$_y$ (0 ≤ x ≤ 1, 0 ≤ y ≤ 1) enthalten. Als Material für die zweite elektrisch leitende Schicht kann zum Beispiel Pt, Ag, Ir, Ag$_{1-x}$Pt$_x$ (0 ≤ x ≤ 1), Ni, Cu, W, Ag$_{1-x}$Pd$_x$ (0 ≤ x ≤ 1), Al, Al dotiert mit Cu, Al dotiert mit Si oder Al dotiert mit Mg verwendet werden.

Auf den jeweils zweiten elektrisch leitenden Schichten der Elektroden 2 und 6 können in geeigneter Kombination der einzelnen Materialien auch noch weitere, beispielsweise dritte, vierte und fünfte, elektrisch leitende Schicht aufgebracht werden. Als Materialien für eine dritte elektrisch leitende Schicht können beispielsweise Ti, Ir, Ag, Cr, Al, IrO$_x$ (0 ≤ x ≤ 2), Ru, Ru$_x$Pt$_{1-x}$ (0 ≤ x ≤ 1), Pt$_x$Al$_{1-x}$ (0 ≤ x ≤ 1), RhO$_x$ (0 ≤ x ≤ 2), Pt$_x$Rh$_{1-x}$ (0 ≤ x ≤ 1) oder ITO verwendet werden. Eine vierte elektrisch leitende Schicht kann beispielsweise IrO$_x$ (0 ≤ x ≤ 2), RuO$_x$ (0 ≤ x ≤ 2), Ru$_x$Pt$_{1-x}$ (0 ≤ x ≤ 1), Pt$_x$Al$_{1-x}$ (0 ≤ x ≤ 1), RhO$_x$ (0 ≤ x ≤ 2), Pt$_x$Rh$_{1-x}$ (0 ≤ x ≤ 1) oder ITO enthalten. Für eine fünfte elektrisch leitende Schicht kann zum Beispiel RuO$_x$ (0 ≤ x ≤ 2) oder Ru$_x$Pt$_{1-x}$ (0 ≤ x ≤ 1) verwendet werden.

Auf gegenüberliegenden Seiten des keramischen, passiven Bauelementes kann wenigstens eine erste und eine zweite Stromzuführung angebracht werden. Als Stromzuführung kann ein galvanischer SMD-Endkontakt aus Cr/Cu, Ni/Sn oder Cr/Cu, Cu/Ni/Sn oder Cr/Ni, Pb/Sn oder ein Bump-end-Kontakt oder eine Kontaktfläche eingesetzt werden.

Das Dielektrikum 5 kann auch multiple Schichten, beispielsweise Doppel-, Dreifach- oder Vierfachschichten, aufweisen.

Weiterhin kann auf dem Trägersubstrat 1 eine Antireaktionsschicht aus beispielsweise TiO$_2$, Al$_2$O$_3$, ZrTiO$_4$ oder ZrO$_2$ abgeschieden werden. Bei Verwendung von Silicium als Trägersubstrat 1 kann das Trägersubstrat 1 mit einer Passivierungsschicht aus SiO$_2$ versehen werden.

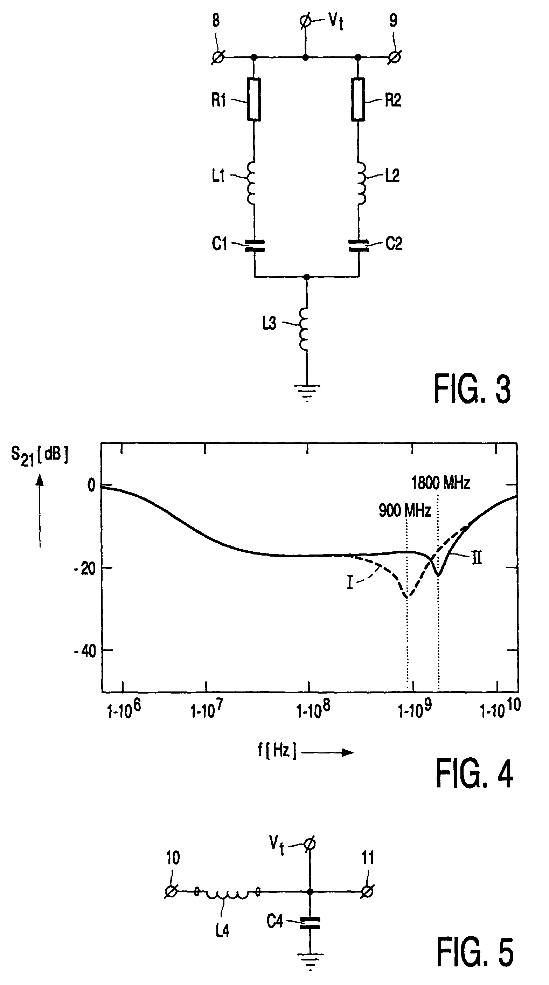

Fig. 3 zeigt eine RCL-Filteranordnung bestehend aus einem Kondensator C1 mit definierter Kapazität, einem abstimmbaren Kondensator C2 und zwei Widerständen R1 und R2 sowie drei Induktivitäten L1 bis L3. Der RCL-Filter weist eine erste Reihenschaltung eines Widerstandes R1, einer Induktivität L1 und eines Kondensators C1 auf; die parallel zu einer zweiten Reihenschaltung eines Widerstandes R2, einer Induktivität L2 und einem Kondensator C2 geschaltet ist. In Reihe zu dieser Parallelschaltung liegt die Induktivität L3, deren einer Anschluss auf Erdpotential liegt. Die Parallelschaltung ist somit auf einer Seite mit der Induktivität L3 verbunden und auf der anderen Seite liegen sowohl das Potential V$_t$ als auch die Anschlüsse 8 und 9.

In Fig. 5 ist die Schaltungsanordnung eines passiven LC-Verzögerungsgliedes bestehend aus einer Induktivität L4 und einem Kondensator C4, die miteinander verbunden sind, gezeigt. Der Verbindungspunkt zwischen der Induktivität L4 und dem Kondensator C4 ist mit einem Abgriff 10 verbunden und liegt auf dem Potential V$_t$. Der andere Anschluss liegt an einem Abgriff 11. Der andere Anschluss des Kondensators C4 liegt auf Erdpotential.

Im folgenden werden Ausführungsformen der Erfindung erläutert, die beispielhafte Realisierungsmöglichkeiten darstellen.

Ausführungsbeispiel 1

Auf einem Trägersubstrat 1 aus Al$_2$O$_3$ mit einer Planarisierungsschicht aus Glas wurde zunächst eine Antireaktionsschicht aus TiO$_2$ und anschließend eine erste elektrisch leitende Schicht 3 aus Ti (10 nm) abgeschieden. Auf diese erste elektrisch leitende Schicht 3 wurde eine zweite elektrisch leitende Schicht 4 aus Pt (500nm) mittels Sputtern abgeschieden und die beiden Schichten wurden fotolithografisch strukturiert. Anschließend wurde ein Dielektrikum 5 aus Pb(Zr$_{0.53}$Ti$_{0.47}$)O$_3$ dotiert mit 5 % Lanthan mittels eines Sol-Gel-Verfahrens abgeschieden, bei ca. 600 °C in Sauerstoffatmosphäre getempert und fotolithografisch strukturiert. Die Dicke des Dielektrikums betrug 0.75 μm. Im nächsten Schritt wurde eine Schicht aus Pt (500 nm) abgeschieden und fotolithografisch zu einer Elektrode 6 strukturiert. Über dem gesamten Bauelement wurde eine Schutzschicht 7 aus Si$_3$N$_4$ und Polyimid abgeschieden. Außerdem wurden auf gegenüberliegenden Seiten des Bauelementes Cr/Cu, Ni/Sn SMD-Endkontakte als Stromzuführungen befestigt.

In Fig. 2 ist der Verlauf der Kapazität des keramischen, passiven Bauelementes mit der angelegten Spannung gezeigt.

Zur Erreichung desselben Abstimmbereiches der Kapazität bei niedrigeren Spannungen als in Fig. 2 gezeigt wurden keramische passive Bauelemente mit einer Dicke des Dielektrikums 5 von d = 0.25 μm nach dem oben erläuterten Verfahren hergestellt. Bei einer Flächenkapazität von 28 nF/mm$^2$ wurde ein kera-

misches passives Bauelement mit einer Kapazität von 50 pF auf einer aktiven Fläche von ca. 1800 $\mu m^2$ (42.5 $\mu m$ * 42.5 $\mu m$) und ein keramisches passives Bauelement mit einer Kapazität von 5 pF auf einer aktiven Fläche von 180 $\mu m^2$ (13.4 $\mu m$ * 13.4 $\mu m$) hergestellt.

Die derart dargestellten keramischen, passiven Bauelemente wurden in Mobiltelefonen anstelle von Kapazitätsvariations-Dioden eingesetzt.

Ausführungsbeispiel 2:

Mit Hilfe des im Ausführungsbeispiel 1 erläuterten Verfahrens wurde ein keramisches, passives Bauelement hergestellt, dessen Kapazität in einem Bereich von 17 pF bis 56 pF abstimmbar war.

Dieses keramische passive Bauelement wurde verwendet, um ein abstimmbares RCL-Filter, das entweder bei 900 MHz oder 1800 MHz starke Dämpfung aufweisen soll, zu realisieren. Dazu wurden ein Kondensator C1 mit definierter Kapazität und ein abstimmbarer Kondensator C2 in einer RCL-Kombination mit zwei Widerständen R1 und R2 und drei Induktivitäten L1 bis L3 gemäß der Schaltungsordnung in Fig. 3 angeordnet. Dabei galt: R1 = 5 $\Omega$, L1 = 0.26 nH, C1 = 2.8 nF und
R2 = 0.5 $\Omega$, L2 = 0.26 nH, C2 = variabel zwischen 17 und 56 pF und
L3 = 0.3 nH.
Durch Anlegen einer Gleichspannung von einigen Volt kann die Kapazität des Kondensators C2 zwischen 17 und 56 pF variiert und somit der Bereich einer starken Absorption in der Filtercharakteristik wie in Fig. 4 gezeigt zwischen 900 und 1800 MHz hin und her geschoben werden. Dabei entspricht Kurve 1 einem Kapazitätswert des Kondensators C2 von 56 pF und Kurve II einem Kapazitätswert von 17 pF.

Ausführungsbeispiel 3:

Mit Hilfe des im Ausführungsbeispiel 1 erläuterten Verfahrens wurde ein keramisches, passives Bauelerent hergestellt, dessen Kapazität in einem Bereich von 1.4 nF bis 2.8 nF bei Anlegen einer Gleichspannung von einigen Volt abstimmbar war.

Das keramische passive Bauelement wurde verwendet, um ein passives LC-Vezögerungsglied mit elektrisch veränderbarer Verzögerungszeit $t_d$ zu realisieren. Dazu wurde der abstimmbare Kondensator C4 mit einer Induktivität L4 von 5.7 nH wie in Fig. 5 gezeigt angeordnet.

Die Verzögerungszeit $t_d$, die sich zu $t_d = \sqrt{L*C}$ ergibt, kann von 4 ns bei einem Kapazitätswert von 2.8 nF durch Veränderung der Kapazität auf 1.4 nF auf 2.8 ns verkürzt werden.

**Patentansprüche**

1. Keramisches, passives Bauelement, welches ein Trägersubstrat (1),

   wenigstens eine darüberliegende erste Elektrode (2),
   wenigstens ein darüberliegendes Dielektrikum (5) und
   wenigstens eine darüberliegende zweite Elektrode (6) aufweist
   <u>dadurch gekennzeichnet,</u>
   dass das Dielektrikum (5) eine ferroelektrische Keramik mit einer spannungsabhängigen relativen Dielektrizitärskonstanten $\varepsilon_r$ enthält.

2. Keramisches, passives Bauelement nach Anspruch 1,
   <u>dadurch gekennzeichnet,</u>

   dass als ferroelektrische Keramik mit einer spannungsabhängigen relativen Dielektrizitätskonstanten $\varepsilon_r$ Pb($Zr_xTi_{1-x}$)$O_3$ ($0 \leq x \leq 1$) mit und ohne Bleiüberschuss, $Ba_{1-x}Sr_xTiO_3$ ($0 \leq x \leq 1$), $Pb_{1-1.5y}La_y$($Zr_xTi_{1-x}$)$O_3$ ($0 \leq x \leq 1$, $0 \leq y \leq 0.2$), Pb($Zr_xTi_{1-x}$)$O_3$ ($0 \leq x \leq 1$) mit Nb-Dotierungen, $Pb_{1-\alpha y}La_yTiO_3$ ($0 \leq y \leq 0.3$, $1.3 \leq \alpha \leq 1.5$), (Pb,Ca)$TiO_3$, $BaTiO_3$ mit und ohne Dotierungen, $SrZr_xTi_{1-x}O_3$ ($0 \leq x \leq 1$) mit und ohne Mn Dotierungen, $BaZr_xTi_{1-x}O_3$ ($0 \leq x \leq 1$), $SrTiO_3$ mit Dotierungen von z.B. La, Nb, Fe oder Mn, Pb($Mg_{1/3}Nb_{2/3}$)$O_3]_x$-[$PbTiO_3]_{1-x}$ ($0 \leq x \leq 1$), (Pb,Ba,Sr)($Mg_{1/3}Nb_{2/3}$)$_xTi_y$($Zn_{1/3}Nb_{2/3}$)$_{1-x-y}O_3$ ($0 \leq x \leq 1$, $0 \leq y \leq 1$, $x+y \leq 1$), $PbNb_{4/5x}$(($Zro_{0.6}Sn_{0.4}$)$_{1-y}Ti_y$))$_{1-x}O_3$ ($0 \leq x \leq 0.9$, $0 \leq y \leq 1$), ($Ba_{1-x}Ca_x$)$TiO_3$ ($0 \leq x \leq 1$), ($Ba_{1-x}Sr_x$)$TiO_3$ ($0 \leq x \leq 1$), ($Ba_{1-x}Pb_x$)$TiO_3$ ($0 \leq x \leq 1$), ($Ba_{1-x}Sr_x$)($Ti_{1-x}Zr_x$)$O_3$ ($0 \leq x \leq 1$, $0 \leq y \leq 1$),
   a) Pb($Mg_{1/2}W_{1/2}$)$O_3$
   b) Pb($Fe_{1/2}Nb_{1/2}$)$O_3$
   c) Pb($Fe_{2/3}W_{1/3}$)$O_3$
   d) Pb($Ni_{1/3}Nb_{2/3}$)$O_3$
   e) Pb($Zn_{1/3}Nb_{2/3}$)$O_3$
   f) Pb($Sc_{1/2}Ta_{1/2}$)$O_3$

   sowie Kombinationen der Verbindungen a)- f) mit $PbTiO_3$ und Pb($Mg_{1/3}Nb_{2/3}$)$O_3$ mit und ohne Bleiüberschuss verwendet wird.

3. Keramisches, passives Bauelement nach Anspruch 1,
   <u>dadurch gekennzeichnet.</u>

   dass die erste Elektrode (2) und/oder die zweite Elektrode (6) wenigstens eine erste und eine zweite elektrisch leitende Schicht enthält.

4. Keramisches, passives Bauelement nach Anspruch 3,
   <u>dadurch gekennzeichnet,</u>

dass die erste elektrisch leitende Schicht der Elektroden (2,6) Ti, Cr, $Ni_xCr_y$ ($0 \leq x \leq 1$, $0 \leq y \leq 1$) oder $Ti_xW_y$ ($0 \leq x \leq 1$, $0 \leq y \leq 1$) enthält.

5. Keramisches, passives Bauelement nach Anspruch 3,
dadurch gekennzeichnet,

dass die zweite elektrisch leitende Schicht der Elektroden (2,6) ein Metall oder eine Legierung enthält.

6. Keramisches, passives Bauelement nach Anspruch 1,
dadurch gekennzeichnet,

dass das Trägersubstrat (1) ein keramisches Material, ein keramisches Material mit einer Planarisierungsschicht aus Glas, ein glaskeramisches Material, ein Glasmaterial oder Silicium enthält.

7. Keramisches, passives Bauelement nach Anspruch 1,
dadurch gekennzeichnet,

dass das Dielektrikum (5) multiple Schichten aufweist.

8. Keramisches, passives Bauelernent nach Anspruch 1,
dadurch gekennzeichnet,

dass über dem gesamten Bauelement eine Schutzschicht (7) aus einem anorganischen Material und/oder einem organischen Material aufgebracht ist.

9. Spannungskontrollierter Oszillator mit als kapazitive Komponente dienendem keramischen, passiven Bauelement, welches ein Trägersubstrat (1), wenigstens eine darüberliegende erste Elektrode (2), wenigstens ein darüberliegendes Dielektrikum (5) und wenigstens eine darüberliegende zweite Elektrode (6) aufweist,
dadurch gekennzeichnet,

dass das Dielektrikum (5) eine ferroelektrische Keramik mit einer spannungsabhängigen relativen Dielektrizitätskonstanten $\varepsilon_r$ enthält.

10. Filter mit als kapazitive Komponente dienendem keramischen, passiven Bauelement, welches ein Trägersubstrat (1), wenigstens eine darüberliegende erste Elektrode (2), wenigstens ein darüberliegendes Dielektrikum (5) und wenigstens eine darüberliegende zweite Elektrode (6) aufweist,
dadurch gekennzeichnet,

dass das Dielektrikum (5) eine ferroelektrische Keramik mit einer spannungsabhängigen relativen Dielektrizitätskonstanten $\varepsilon_r$ enthält.

11. Verzögerungsleitung mit als kapazitive Komponente dienendem keramischen, passiven Bauelement, welches ein Trägersubstrat (1), wenigstens eine darüberliegende erste Elektrode (2), wenigstens ein darüberliegendes Dielektrikum (5) und wenigstens eine darüberliegende zweite Elektrode (6) aufweist,
dadurch gekennzeichnet,

dass das Dielektrikum (5) eine ferroelektrische Keramik mit einer spannungsabhängigen relativen Dielektrizitätskonstanten $\varepsilon_r$ enthält.

12. Verwendung eines keramischen, passiven Bauelementes, welches ein Trägersubstrat (1), wenigstens eine darüberliegende erste Elektrode (2), wenigstens ein darüberliegendes Dielektrikum (5) mit einer spannungsabhängigen relativen Dielektrizitätskonstanten $\varepsilon_r$ und wenigstens eine darüberliegende zweite Elektrode (6) aufweist, als kapazitive Komponente.

## FIG. 1

## FIG. 2

FIG. 3

FIG. 4

FIG. 5